# EUROPEAN PATENT APPLICATION

(11) **EP 2 421 033 A2**
(43) Date of publication of application: **22.02.2012**
(21) Application number: 11176509.5
(22) Date of filing: 04.08.2011
(51) Int. Cl.: H01L 21/67

(54) **Slit valve for vacuum chamber module**

(30) Priority: 17.08.2010 US 857810
(71) Applicant: PrimeStar Solar, Inc, Arvada, CO 80004 (US)
(72) Inventor: Black, Russell Weldon, Arvada, CO Colorado 80004 (US)
(74) Representative: Bedford, Grant Richard

(57) **Abstract**

A slit valve assembly (100) is configured for attachment to a vacuum chamber module (65) to seal a slot opening (106) in a wall (104) of the module in a closed position and to provide access through the slot opening in an open position. The valve assembly includes a rotatable shaft (108) driven by a rotary actuator (110) between an open rotational position and a closed rotational position. An elongated seal plate (112) seals against the module wall over the slot opening in the closed rotational position of the shaft. At least one arm member (118) connects the seal plate with the shaft. The arm member rotates with the shaft and is pivotally attached to the seal plate. The seal plate is biased to an articulated position relative to the arm member.

## Description

The present invention relates generally to the field of vacuum chamber modules, and more particularly to an improved slit valve used with such modules.

Production of thin film photovoltaic (PV) modules (also referred to as "solar panels") typically involves conveyance of a substrate, such as a glass panel, into and out of a vapor deposition chamber wherein a thin film layer of a semiconductor material is deposited onto the surface of the substrate. The process typically involves conveying the substrates through valves into and out of one or more vacuum chamber modules. The valves create a lock through which the substrates are conveyed and generally define a slot that is slightly larger than the cross section of the substrate in the open position of the valve. As such, the valves are generally referred to as "slit valves" in the art.

Conventional slit valves are typically a self-contained unit that includes a housing that mounts onto the vacuum chamber module. These valves are not versatile and can be quite expensive. Different valve configurations are needed for inlet valves and outlet valves. In addition, precise tolerances are needed for mating the valve housings onto the module housing to ensure proper operation of the valve and integrity of the vacuum chamber module during a vacuum process. Repair or replacement of the conventional slit valves can result in significant down time of the module, or the significant expense of maintaining an on-hand inventory of replacement valves.

Accordingly, the industry would benefit from an improved slit valve design particularly suited for vacuum chamber modules that is simple, robust, and eliminates certain of the disadvantages of conventional slit valves.

Various aspects and advantages of the invention will be set forth in part in the following description, or may be clear from the description, or may be learned through practice of the invention.

In accordance with various aspects of the invention, a slit valve assembly is configured for attachment to any manner of vacuum chamber module, for example a module used in a vapor deposition processing line for the manufacture of solar panels. The valve assembly is provided to seal a slot opening in a wall of the module in a closed position, and to provide access through the slot opening in an open position for passage of substrates through the module. The valve assembly includes a rotatable shaft driven by a rotary actuator between an open rotational position and a closed rotational position. An elongated seal plate is configured with the shaft and has a sealing face configured for sealing against the module wall over the slot opening in the closed rotational position of the shaft. At least one arm member operably connects the seal plate to the shaft. A plurality of spaced apart arm members may be used for this purpose. The arm member is fixed to the shaft so as to rotate with the shaft and move the seal plate between the open and closed rotational positions. The arm member is pivotally attached to the seal plate and the seal plate is biased (i.e., by a spring or other biasing element) to an articulated position relative to the arm member. In this manner, as the shaft rotates towards the closed rotational position, an end of the seal plate initially engages the module wall and the seal plate pivots into a parallel sealing position relative to the module wall as the shaft continues to rotate to the closed rotational position.

In a particular embodiment, a compressible seal is provided on the sealing face of the seal plate, such as an O-ring seated with a groove defmed in the sealing face.

In still another embodiment, a plurality of bearing supports may be configured along the rotatable shaft for mounting the shaft on the module wall. If the valve assembly is configured as an internal slit valve such that the seal plate is disposed within the module and seals against an internal face of the module wall, the bearing supports may have a standoff component so as to extend through bores in the module wall to mount to an external face of the module wall. If the valve assembly is configured as an external slit valve such that the seal plate seals against an external face of the module wall, the bearing supports may be mountable to the external face of the module wall.

Variations and modifications to the embodiments of the slit valve assembly discussed above are within the scope and spirit of the invention and may be further described herein.

Embodiments of the invention may also encompasses any manner of vacuum chamber module for processing substrates in a vacuum. The module includes a housing having end walls with slots defined therein for passage of substrates into and out of the housing. A slit valve assembly in accordance with any of the embodiments described herein is configured on at least one of the end walls. In a unique embodiment, a slit valve assembly is provided at the inlet and outlet end walls of the module.

Variations and modifications to the embodiment of the vapor chamber module discussed above are within the scope and spirit of the invention and may be further described herein.

Various features, aspects and advantages of the present invention will become better understood with reference to the following description, appended claims, and drawings, in which:
Fig. 1 is front view of an exemplary vapor deposition system incorporating valve assemblies in accordance with aspects of the invention;
Fig. 2 is a perspective view of an embodiment of a slit valve assembly;
Fig. 3 is a side cut-away view of components of the valve assembly of Fig. 2;
Fig. 4 is a perspective view of a module incorporating an inlet and an outlet slit valve assembly;
Fig. 5 is a perspective view of an interior portion of a module; and,
Figs. 6 through 8 are sequential operational views of an embodiment of a slit valve assembly.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment, can be used with another embodiment to yield a still further embodiment. Thus, it is intended that the present invention encompass such modifications and variations as come within the scope of the appended claims and their equivalents.

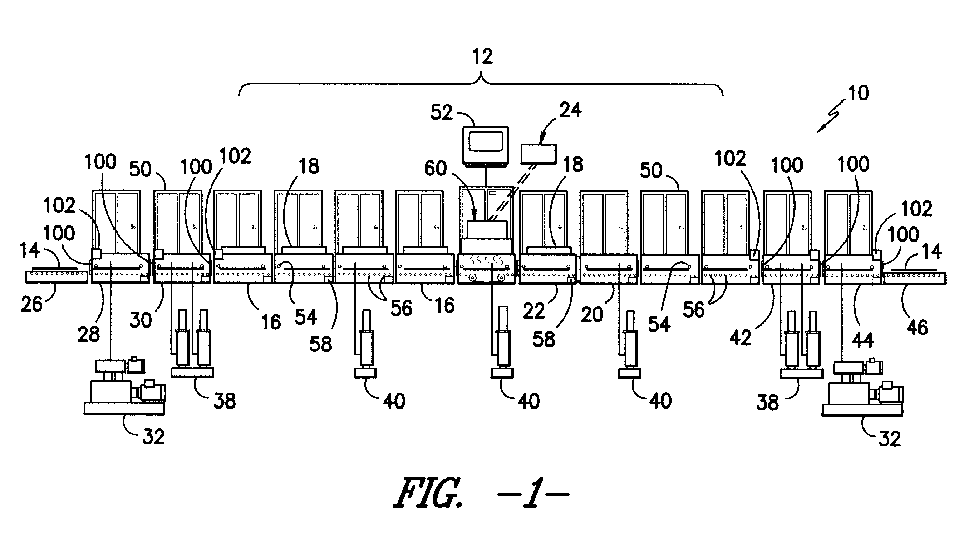

Fig. 1 illustrates an embodiment of a vapor deposition system 10 that may incorporate various embodiments of a slit valve assembly 100 in accordance with aspects of the invention, particularly as components of various types of modules that make up the system 10. For reference and an understanding of a particular environment in which the present slit valve assemblies 100 may be used, the system 10 of Fig. 1 is described below, followed by a detailed description of particular embodiments of the slit valve assemblies 100. It should be appreciated, however, that the slit valve assembly 100 is not limited to use in the system 10 of Fig. 1. Valve assemblies 100 may be used in any machine or system wherein vacuum slit valves are applicable.

The system 10 is configured for deposition of a thin film layer on a photovoltaic (PV) module substrate 14 (referred to hereafter as "substrate"). The thin film may be, for example, a film layer of cadmium telluride (CdTe). As mentioned, it is generally recognized in the art that a "thin" film layer on a PV module substrate is generally less than about 10 microns (um). Referring to Fig. 1, the exemplary system 10 includes a vacuum chamber 12 defined by a plurality of interconnected modules. Any combination of vacuum pumps 40 may be configured with the interconnected modules to draw and maintain a vacuum effective for the deposition process within the chamber 12. A plurality of interconnected heater modules 16 define a pre-heat section of the vacuum chamber 12 through which the substrates 14 are conveyed and heated to a desired temperature before being conveyed into a vapor deposition apparatus 60. Each of the modules 16 may include a plurality of independently controlled heaters 18, with the heaters defining a plurality of different heat zones. A particular heat zone may include more than one heater 18.

The vapor deposition apparatus 60 may take on various configurations and operating principles within the scope and spirit of the invention, and is generally configured for vapor deposition of a sublimated source material, such as CdTe, as a thin film on the PV module substrates 14. In the embodiment of the system 10 illustrated in Fig. 1, the apparatus 60 is a module that includes a casing in which the internal components are contained, including a vacuum deposition head mounted above a conveyor assembly.

The vacuum chamber 12 also includes a plurality of interconnected cool-down modules 20 within the vacuum chamber 12 downstream of the vapor deposition apparatus 60. The cool-down modules 20 define a cool-down section within the vacuum chamber 12 in which the substrates 14 having the thin film of sublimed source material deposited thereon are allowed to cool at a controlled cool-down rate prior to the substrates 14 being removed from the system 10. Each of the modules 20 may include a forced cooling system wherein a cooling medium, such as chilled water, refrigerant, or other medium is pumped through cooling coils configured with the modules 20.

In the illustrated embodiment of system 10, at least one post-heat module 22 is located immediately downstream of the vapor deposition apparatus 60 and before the cool-down modules 20. As the leading section of a substrate 14 is conveyed out of the vapor deposition apparatus 60, it moves into the post-heat module 22, which maintains the temperature of the substrate 14 at essentially the same temperature as the remaining portion of the substrate 14 within the vapor deposition apparatus 60. In this way, the leading section of the substrate 14 is not allowed to cool while the trailing section of the substrate 14 is still within the vapor deposition apparatus 60. If the leading section of a substrate 14 were allowed to cool as it exited the apparatus 60, a non-uniform temperature would be generated longitudinally along the substrate 14. This condition could result in the substrate breaking from thermal stress.

As diagrammatically illustrated in Fig. 1, a feed device 24 is configured with the vapor deposition apparatus 60 to supply source material, such as granular CdTe. Preferably, the feed device 24 is configured so as to supply the source material without interrupting the continuous vapor deposition process within the apparatus 60 or conveyance of the substrates 14 through the apparatus 60.

Still referring to Fig. 1, the individual substrates 14 are initially placed onto a load conveyor 26, and are subsequently moved into an entry vacuum lock station that includes a load module 28 and a buffer module 30. A "rough" (i.e., initial) vacuum pump 32 is configured with the load module 28 to drawn an initial vacuum, and a "fine" (i.e., high) vacuum pump 38 is configured with the buffer module 30 to increase the vacuum in the buffer module 30 to essentially the vacuum within the vacuum chamber 12. Slit valves 100 in accordance with aspects of the invention are operably disposed between the load conveyor 26 and the load module 28, between the load module 28 and the buffer module 30, and between the buffer module 30 and the vacuum chamber 12. As described in greater detail below, these valves 100 are sequentially actuated by a motor or other type of actuating mechanism 102 in order to introduce the substrates 14 into the vacuum chamber 12 in a step-wise manner without affecting the vacuum within the chamber 12.

An exit vacuum lock station is configured downstream of the last cool-down module 20, and operates essentially in reverse of the entry vacuum lock station described above. For example, the exit vacuum lock station may include an exit buffer module 42 and a downstream exit lock module 44. Sequentially operated slide valves 34 are disposed between the buffer module 42 and the last one of the cool-down modules 20, between the buffer module 42 and the exit lock module 44, and between the exit lock module 44 and an exit conveyor 46. A fine vacuum pump 38 is configured with the exit buffer module 42, and a rough vacuum pump 32 is configured with the exit lock module 44. The pumps 32, 38 and slit valves 100 are sequentially operated to move the substrates 14 out of the vacuum chamber 12 in a step-wise fashion without loss of vacuum condition within the vacuum chamber 12.

The system 10 also includes a conveyor system configured to move the substrates 14 into, through, and out of the vacuum chamber 12. In the illustrated embodiment, this conveyor system includes the load conveyor 26, exit conveyor 46, and a plurality of individually controlled conveyor assemblies 56, with each of the various modules including one of the conveyor assemblies 56. Any combination of these conveyors, 26, 46, and 56 may be configured in accordance with aspects of the invention, and the conveyors may include individual conveyor drive units 58 that control the conveyance rate of substrates 14 through the respective module.

As described, each of the various modules and respective conveyors in the system 10 are independently controlled to perform a particular function. For such control, each of the individual modules may have an associated independent controller 50 configured therewith to control the individual functions of the respective module, including the conveyance rate of the various conveyors and operation of the slit valves 100. The plurality of controllers 50 may, in turn, be in communication with a central system controller 52, as illustrated in Fig. 1. The central system controller 52 can monitor and control (via the independent controllers 50) the functions of any one of the modules so as to achieve an overall desired heat-up rate, deposition rate, cool-down rate, and so forth, in processing of the substrates 14 through the system 10.

Referring to Fig. 1, the various modules may include active-sensing viewport assemblies 54 that detect the presence of the substrates 14 as they are conveyed through the module. The viewport assemblies 54 are in communication with the respective module controller 50, which is in turn in communication with the central controller 52. In this manner, the individual respective conveyor assemblies may be controlled to ensure that a proper spacing between the substrates 14 is maintained and that the substrates 14 are conveyed at the desired constant conveyance rate through the vacuum chamber 12. It should be appreciated that the viewport assemblies may be used for any other control function related to the individual modules or overall system 10.

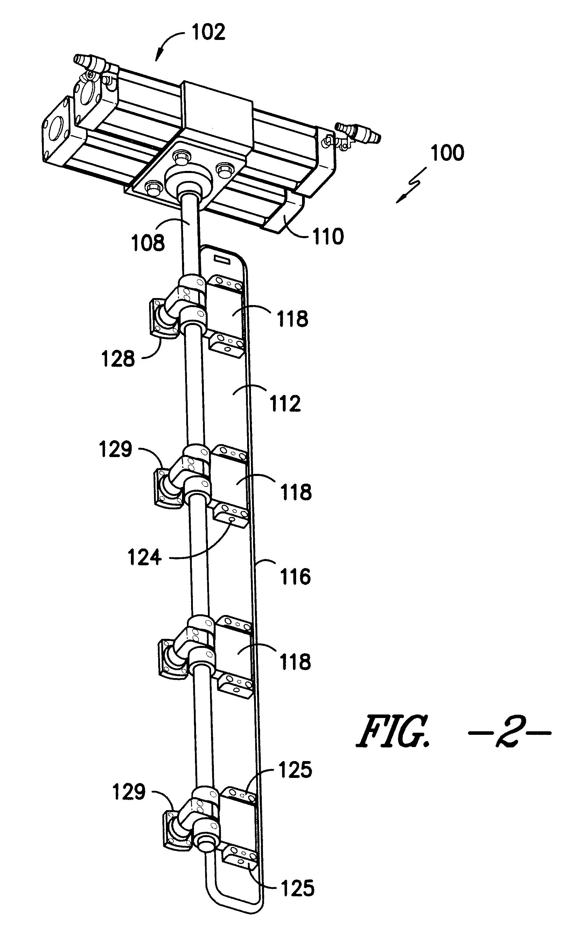

Fig. 2 is a perspective view of an embodiment of a slit valve assembly 100. The assembly 100 is particularly configured to be attached to a vacuum chamber module, such as any one of the modules 16, 20, 22, 42, 44, and the like, of Fig. 1, as discussed above. It should be readily appreciated that the slit valve assembly 100 is not limited by its configuration with any particular type of module.

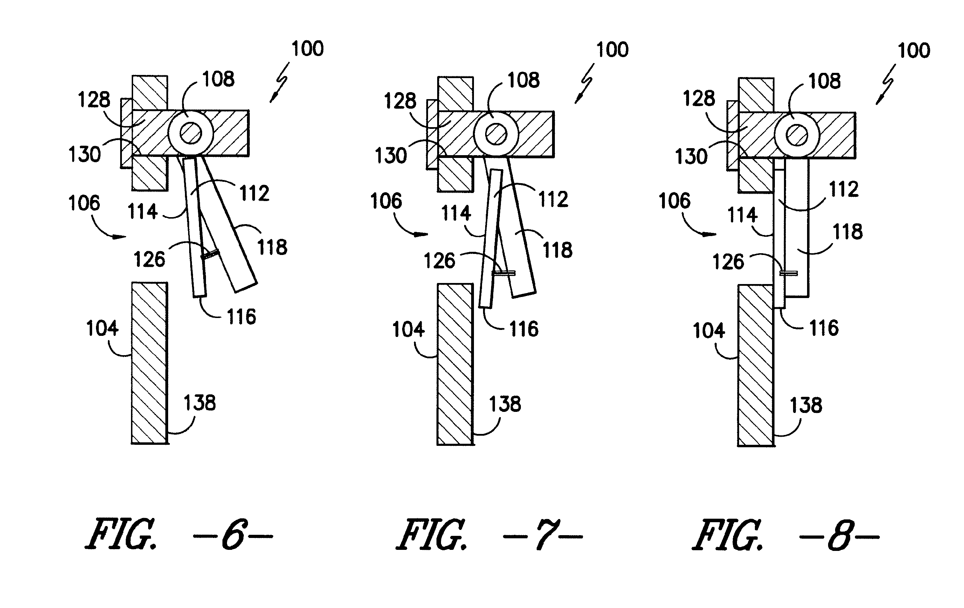

Referring to the sequential operational views of Figs. 6 through 8, the slit valve assembly 100 is configured to seal a slot opening 106 in a wall 104 of any manner of vacuum chamber module in a closed position of the valve assembly 100 as illustrated in Fig. 8, and to provide access through the slot opening 106 in an open position of the valve assembly 100. As discussed above with respect to Fig. 1, each of the slit valve assemblies 100 includes an actuating mechanism 102 (Fig. 2) that moves the valve assembly 100 between the opened and closed positions.

Referring to Fig. 2 in addition to Figs. 6 through 8, the slit valve assembly includes a rotatable shaft 108 that is driven by the actuating mechanism 102. In a particular embodiment, the actuating mechanism 102 may be any manner of conventional rotary actuator 110. This actuator 110 may be, for example, an air drive actuator, piston-type drive actuator, vane-type drive, and the like. Rotary actuators are particularly useful in that they provide more than sufficient torque for the application and take up a relatively small operating area. It should be appreciated, however, that the actuating mechanism need not be a rotary actuator, but may be any type of drive for imparting rotational torque to the shaft 108.

An elongated seal plate 112 includes a sealing face 114 that is configured to seal directly against the module wall 104 over the slot opening 106 in a closed rotational position of the shaft 108, as depicted in Fig. 8. The seal plate 112 is operably connected to the shaft 108, for example by at least one arm member 118. In the illustrated embodiment, the seal plate 112 is connected to the shaft 108 by a plurality of spaced apart members 118. It should be readily appreciated that any configuration of arm members 118 or other type of rigid or fixed connection between the seal plate 112 and shaft 108 may be utilized in this regard.

The arm members 118 are rotationally fixed to the shaft 108 so as to rotate with the shaft. At the same time, the arm members 118 are pivotally attached to the seal plate 112, as particularly illustrated in Figs. 6 through 8. The seal plate 112 is biased by a spring 126 or any other suitable biasing mechanism to an articulated non-parallel position relative to the arm member 118, as depicted in Fig. 6. As the shaft 108 rotates towards its closed rotational position, an end 116 of the seal plate 112 is positioned so as to initially contact the face 138 (e.g., an internal face in the depicted embodiment) of the module 104, as particularly depicted in Fig. 7. As the shaft 108 continues to rotate to the closed position, the seal plate 112 continues to pivot relative to the arm member 118 to a final sealing position wherein the seal plate 112 is parallel to and sealed against the module wall 104. The seal plate may also be parallel to the arm member 118 in its sealed position, as depicted in Fig. 8. It should be understood that the degree of articulation between the seal plate 112 and arm members 118 is grossly exaggerated in Figs. 6 through 8 for purposes of explaining certain operational principles of the components. Depending on the system configuration, less than five degrees, or even less than two degrees, of articulation may be all that is necessary.

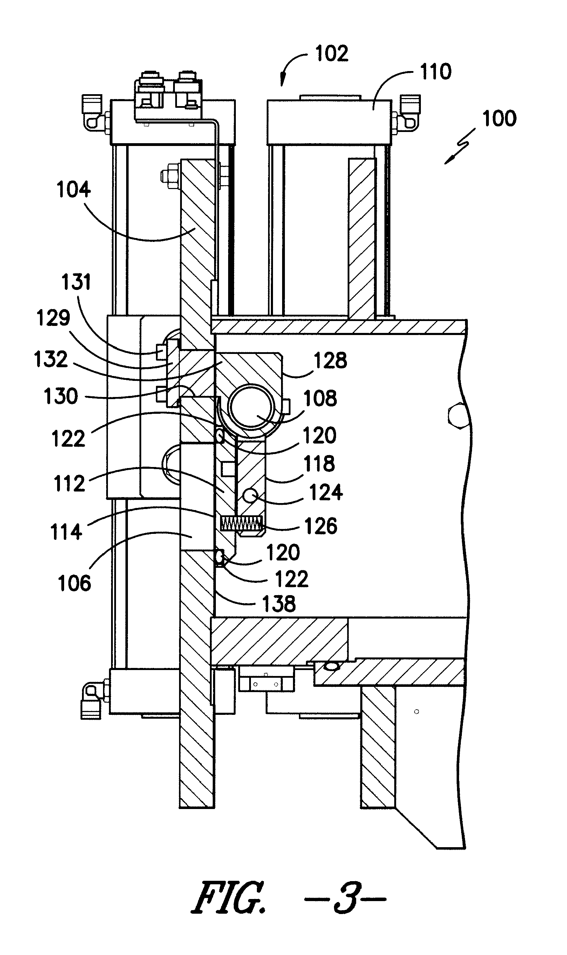

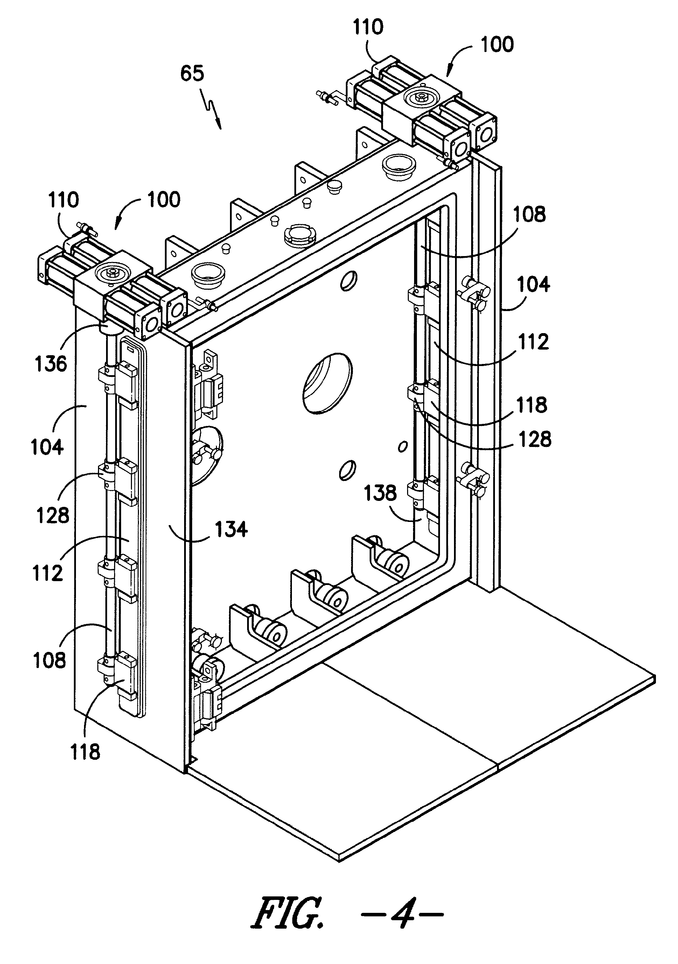

Fig. 3 is a more detailed cross-sectional view through certain components of the slit valve assembly 100 in its closed rotational position. In this particular embodiment, the slit valve assembly 100 is configured as an internal slit valve that is disposed within the vacuum chamber and thus rotates or swings between the opened and closed positions within the vacuum chamber. Referring to Fig. 4, an internal slit valve assembly 100 is illustrated on the right-hand side of the vertical vacuum chamber module 65 and an external slit valve assembly 100 is depicted on the left-hand side of the module 65. The external slit valve assembly 100 seals against the outer external face 134 of the left-hand module wall 104 and, thus, swings between the opened and closed position externally of the vacuum chamber.

Referring to Figs. 2 and 3 in particular, any manner of suitable articulation joint 124 is configured between the arm members 118 and the seal plate 112. In the illustrated embodiment, each of the arm members 118 is pivotally attached to the seal plate 112 by way of pivot blocks 125 that may be disposed on opposite sides of the arm members 118. A pivot pin, axle, or like device extends through the pivot blocks 125 and the arm members 118 at the articulation joint 124. A sufficient clearance is provided between the opposed surfaces of the arm members 118 and seal plate 112 to provide for the desired degree of articulation between the components.

Referring to Fig. 3, in a particular embodiment, a compressible seal may be provided on the seal face 114 of the seal plate 112. For example, a compressible O-ring 120 may be seated within a groove 122 defmed in the seal face 114. The O-ring 120 compresses against the internal face 138 (or external face 134) as the seal plate 112 moves into its closed rotational position and, thus, ensures a vacuum seal over the slot opening 106. Because of the biased articulation motion of the seal plate 112 relative to the shaft 108 and arm members 118, once the seal plate 112 contacts the module wall 104, the seal plate 112 is brought into a parallel, sealing configuration without causing rolling of the O-ring within the groove 122. This is a significant advantage in that it substantially extends the life of the O-ring seal and also ensures a uniform application of sealing pressure around the slot opening 106.

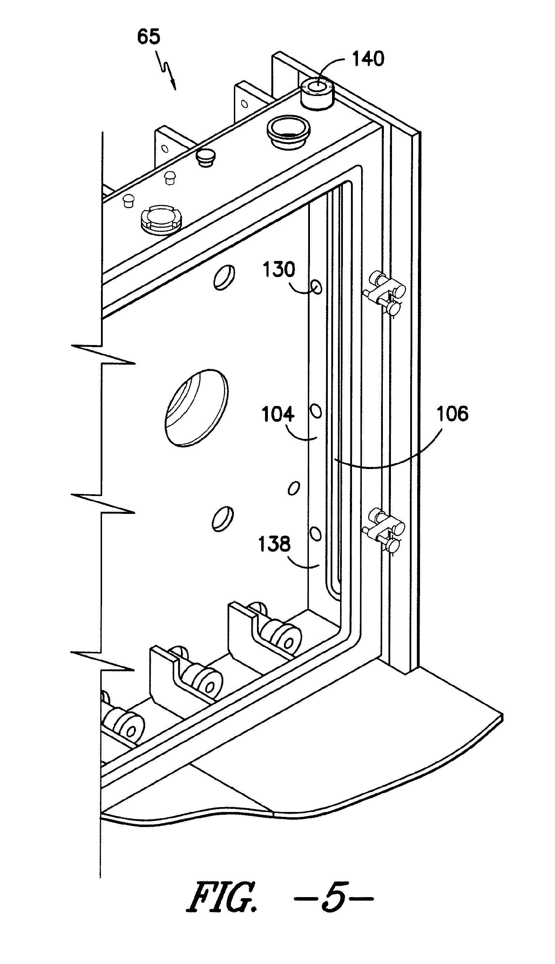

As particularly seen in Figs. 2 and 4, a plurality of bearing supports 128 may be operationally disposed along the length of the shaft 108 for mounting onto the module wall 104. The bearing supports 128 provide for the rotational movement of the shaft 108 and are rigidly fixed to the arm member 118 by any suitable means. The arm members 118 may be an integral component with the bearing supports 128, or may be a separate component that is subsequently fixed to the bearing supports 128. Referring to Figs. 3 and 5 wherein the slit valve assembly 100 is configured as an internal slit valve, the bearing support 128 may include a stand off component 132 (e.g., an extension) that extends through a bore 130 defined through the module wall 104. In this manner, the bearing supports 128 can be affixed to the outer external face of the module wall 104, for example by means of a flange 129 and bolts 131 instead of being mounted to the internal face 138. This configuration provides significant advantages in maintenance and replacement of the slit valve components. Also, the external machined face of the module wall 104 is a precise reference surface datum for proper location of the bearing supports 128 (via the stand off components 132) relative to the inside face of the wall 104 to ensure proper orientation, movement, and sealing of the seal plate 112.

In the embodiment wherein the slit valve assembly 100 is externally mounted, as in the left-hand embodiment in Fig. 4, the bearing supports 128 are mounted directly against the external face 134 of the module wall 104. Because the shaft 108 does not penetrate through the module into the vacuum chamber, any manner of suitable bearing block 136 may be configured between the rotary actuator 110 and the external face 134 of the module wall 104. However, when the slit valve assembly 100 is configured as an internal valve, as in the right-hand embodiment of Fig. 4, the shaft 108 penetrates through the side wall of the vacuum module 65. Referring to Fig. 5, a shaft rotary seal 140 is provided for this purpose. The shaft rotary seal 140 may be any manner of rotary seal that is suitable for maintaining a vacuum seal around the shaft 108 at the location where the shaft penetrates through the side wall of the module 65. The position of the shaft rotary seal 140 is important for the proper operation of the assembly 100 and, in this regard, the bore in the side wall of the module 65 in which the seal 140 is seated is precisely located relative to the machined outer surface of the module wall 104, which thus also serves as a reference surface datum for the shaft rotary seal 140.

As mentioned, it should be fully appreciated that the present invention also encompasses any manner of vacuum chamber module that incorporates one or more of the slit valve assemblies 100 as described herein. In a particular embodiment, the vacuum chamber module may be any one of the modules discussed above in Fig. 1 wherein the module is an in-line component in a vacuum deposition processing line for the manufacture of solar panels.

This written description uses examples to disclose the invention, including the preferred mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

Various aspects and embodiments of the present invention are defined by the following numbered clauses:
1. A slit valve assembly configured for attachment to a vacuum chamber module to seal a slot opening in a wall of the module in a closed position of said valve assembly and to provide access through the slot opening in an open position of said valve assembly, comprising:
   a rotatable shaft driven by a rotary actuator between an open rotational position and a closed rotational position;
   an elongated seal plate having a sealing face configured for sealing against the module wall over the slot opening in said closed rotational position of said shaft; and
   at least one arm member operably connecting said seal plate with said shaft, said arm member fixed to said shaft so as to rotate with said shaft and pivotally attached to said seal plate;
   wherein said seal plate is biased to an articulated position relative to said arm member such that as said shaft rotates towards said closed rotational position, an end of said seal plate initially engages the module wall and said seal plate pivots into a parallel sealing position relative to the module wall as said shaft continues to rotate to said closed rotational position.
2. The valve assembly as in clause 1, further comprising a compressible seal provided on said sealing face of said seal plate.
3. The valve assembly as in any preceding clause, wherein said compressible seal comprises an O-ring seal seated with a groove defined in said sealing face.
4. The valve assembly as in any preceding clause, further comprising an articulation joint and a biasing spring configured between said arm member and said seal plate.
5. The valve assembly as in any preceding clause, further comprising a plurality of bearing supports configured along said rotatable shaft, said bearing supports configured for mounting to the module wall.
6. The valve assembly as in any preceding clause, wherein said valve assembly is configured as an internal slit valve such that said seal plate is disposed within and seals against an internal face of the module wall, said bearing supports having a standoff so as to extend through bores in the module wall to mount to an external face of the module wall.
7. The valve assembly as in any preceding clause, further comprising a shaft rotary seal assembly configured for mounting in a bore of an adjacent wall of the module to allow penetration of said shaft into the vacuum chamber module.
8. The valve assembly as in any preceding clause, wherein said valve assembly is configured as an external slit valve such that said seal plate seals against an external face of the module wall, said bearing supports mountable to the external face of the module wall.
9. The valve assembly as in any preceding clause, further comprising a rotary bearing block configured for mounting externally to an adjacent wall of the module.
10. A vacuum chamber module for processing substrates in a vacuum, comprising:
   a housing having end walls with a slot opening defined therein for passage of substrates into and out of said housing;
   a slit valve assembly configured on at least one of said end walls, said valve assembly further comprising
   a rotatable shaft driven by a rotary actuator between an open rotational position and a closed rotational position;
   an elongated seal plate having a sealing face configured for sealing against said module end wall over said slot opening in said closed rotational position of said shaft; and,
   at least one arm member operably connecting said seal plate with said shaft, said arm member fixed to said shaft so as to rotate with said shaft and pivotally attached to said seal plate;
      wherein said seal plate is biased to an articulated position relative to said arm member such that as said shaft rotates towards said closed rotational position, an end of said seal plate initially engages said module end wall and said seal plate pivots into a parallel sealing position relative to said module end wall as said shaft continues to rotate to said closed rotational position.
11. The vacuum chamber module as in any preceding clause, wherein said module is configured as an in-line component in a vacuum deposition processing line for manufacture of solar panels.
12. The vacuum chamber module as in any preceding clause, comprising a respective said slit valve assembly at each of said module end walls.
13. The vacuum chamber module as in any preceding clause, further comprising an O-ring seal seated with a groove defined in said sealing face.
14. The vacuum chamber module as in any preceding clause, further comprising an articulation joint and a biasing spring configured between said arm member and said seal plate.
15. The vacuum chamber module as in any preceding clause, further comprising a plurality of bearing supports configured along said rotatable shaft and mounted to said module end wall.
16. The vacuum chamber module as in any preceding clause, wherein said valve assembly is configured as an internal slit valve on said module end wall at an inlet to said module, said seal plate disposed within said module and sealable against an internal face of said module end wall, said bearing supports mounted to an external face of said module end wall and having a standoff extending through bores in said module end wall to connect to said shaft.
17. The vacuum chamber module as in any preceding clause, further comprising a shaft rotary seal assembly mounted in a bore of an adjacent side wall of said module, said shaft extending through said rotary seal assembly and connected to said rotary actuator.
18. The vacuum chamber module as in any preceding clause, wherein said valve assembly is configured as an external slit valve on said module end wall at an outlet to said module, said seal plate sealable against an external face of said module end wall, said bearing supports mounted to the external face of said module end wall.
19. The vacuum chamber module as in any preceding clause, comprising said slit valve assembly at each of an inlet and outlet ones of said module end walls, said valve assembly at said inlet module end wall configured as an internal slit valve with said seal plate disposed within said module and sealable against an internal face of said module end wall, and further comprising a plurality of bearing supports mounted to an external face of said module end wall and having a standoff extending through bores in said module end wall to connect to said shaft.
20. The vacuum chamber module as in any preceding clause, wherein said valve assembly at said outlet module end wall is configured as an as an external slit valve with said seal plate sealable against an external face of said module end wall, and further comprising a plurality of bearing supports mounted to said external face of said module end wall.

## Claims

1. A slit valve assembly (100) configured for attachment to a vacuum chamber module(65) to seal a slot opening (106) in a wall (104)of the module in a closed position of said valve assembly and to provide access through the slot opening in an open position of said valve assembly, comprising:
a rotatable shaft (108) driven by a rotary actuator(110) between an open rotational position and a closed rotational position;
an elongated seal plate(112) having a sealing face (114) configured for sealing against the module wall over the slot opening in said closed rotational position of said shaft; and
at least one arm member (118) operably connecting said seal plate with said shaft, said arm member fixed to said shaft so as to rotate with said shaft and pivotally attached to said seal plate;
wherein said seal plate is biased to an articulated position relative to said arm member such that as said shaft rotates towards said closed rotational position, an end of said seal plate initially engages the module wall and said seal plate pivots into a parallel sealing position relative to the module wall as said shaft continues to rotate to said closed rotational position.

2. The valve assembly (100) as in claim 1, further comprising a compressible seal (120) provided on said sealing face (114) of said seal plate.

3. The valve assembly (100) as in claim 2, wherein said compressible seal (120) comprises an O-ring seal seated with a groove (122) defined in said sealing face (114).

4. The valve assembly (100) as in any preceding claim, further comprising an articulation joint (124) and a biasing spring (126) configured between said arm member (118) and said seal plate (112).

5. The valve assembly (100) as in any preceding claim, further comprising a plurality of bearing supports (128) configured along said rotatable shaft (108), said bearing supports configured for mounting to the module wall (104).

6. The valve assembly (100) as in claim 5, wherein said valve assembly is configured as an internal slit valve such that said seal plate (112) is disposed within and seals against an internal face (138) of the module wall (104), said bearing supports (128) having a standoff (132) so as to extend through bores (130) in the module wall to mount to an external face (134) of the module wall.

7. The valve assembly (100) as in any preceding claim, further comprising a shaft rotary seal (140) assembly configured for mounting in a bore of an adjacent wall of the module to allow penetration of said shaft (108) into the vacuum chamber module (65).

8. The valve assembly (100) as in any preceding claim, wherein said valve assembly is configured as an external slit valve such that said seal plate (112) seals against an external face (134) of the module wall (104), said bearing supports (128) mountable to the external face of the module wall.

9. The valve assembly (100) as in any preceding claim, further comprising a rotary bearing block (136) configured for mounting externally to an adjacent wall of the module (65).

10. A vacuum chamber module (65) for processing substrates (14) in a vacuum, comprising:
a housing having end walls (104) with a slot opening (106) defined therein for passage of substrates into and out of said housing;
a slit valve assembly (100) configured on at least one of said end walls, said valve assembly in accordance with any one of claims 1 to 9.

11. The vacuum chamber module (65) as in claim 10, wherein said module is configured as an in-line component in a vacuum deposition processing line for manufacture of solar panels.

12. The vacuum chamber module (65) as in claim 10 or claim 11, comprising a respective said slit valve assembly (100) at each of said module end walls (104).
